Europäisches Patentamt

European Patent Office

Office européen des brevets

(11) Publication number: **0 131 111**
**B1**

(12) **EUROPEAN PATENT SPECIFICATION**

(45) Date of publication of patent specification: 21.03.90

(51) Int. Cl.⁵: **H 01 L 29/80, H 01 L 29/10**

(21) Application number: 84105301.0

(22) Date of filing: 10.05.84

(54) Semiconductor device having a heterojunction.

(30) Priority: 16.05.83 JP 84223/83

(43) Date of publication of application:
16.01.85 Bulletin 85/03

(45) Publication of the grant of the patent:
21.03.90 Bulletin 90/12

(84) Designated Contracting States:
DE FR GB

(56) References cited:
EP-A-0 025 742
EP-A-0 064 370
DE-A-2 913 068

(73) Proprietor: HITACHI, LTD.
6, Kanda Surugadai 4-chome Chiyoda-ku
Tokyo (JP)

(72) Inventor: Yasushi, Sawada
3-1, Higashi-Koigakubo
Kokubunji-shi Tokyo (JP)
Inventor: Yasuhiro, Shiraki
1-106, 3-26-1, Hirayama
Hino-shi Tokyo (JP)
Inventor: Yoshifumi, Katayama
1303-9, Shimotomi
Tokorozawa-shi Saitama-ken (JP)
Inventor: Yoshimasa Murayama
4-2-1-320, Maehara-cho
Koganei-shi Tokyo (JP)
Inventor: Ken, Yamaguchi
2-5-12, Maesawa
Higashikurume-shi Tokyo (JP)
Inventor: Eiichi, Maruyama
1572-3, Josuihoncho
Kodaira-shi Tokyo (JP) ·

(74) Representative: Strehl, Peter, Dipl.-Ing. et al
Patentanwälte Strehl Schübel-Hopf Groening
Maximilianstrasse 54 Postfach 22 14 55
D-8000 München 22 (DE)

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid. (Art. 99(1) European patent convention).

Courier Press, Leamington Spa, England.

# Description

## Background to the Invention
### Field of the Invention

The present invention relates to a semiconductor device having a heterojunction, and more particularly to a field-effect semiconductor device which is well suited in case of forming an integrated circuit.

## Description of the Prior Art

Gallium arsenide (GaAs) has an electron mobility much higher than that of silicon, and is a material suited for fabricating a high speed semiconductor device. Since, however, it is difficult of forming an insulator layer of good quality, a MOS (Metal-Oxide-Semiconductor) type field effect transistor as made of silicon has not been realized. In recent years, however, it has been revealed that, when an aluminium gallium arsenide (AlGaAs) crystal which is doped with a donor impurity is used instead of the insulator layer, carriers are induced at the interface thereof, so a field effect transistor can be fabricated.

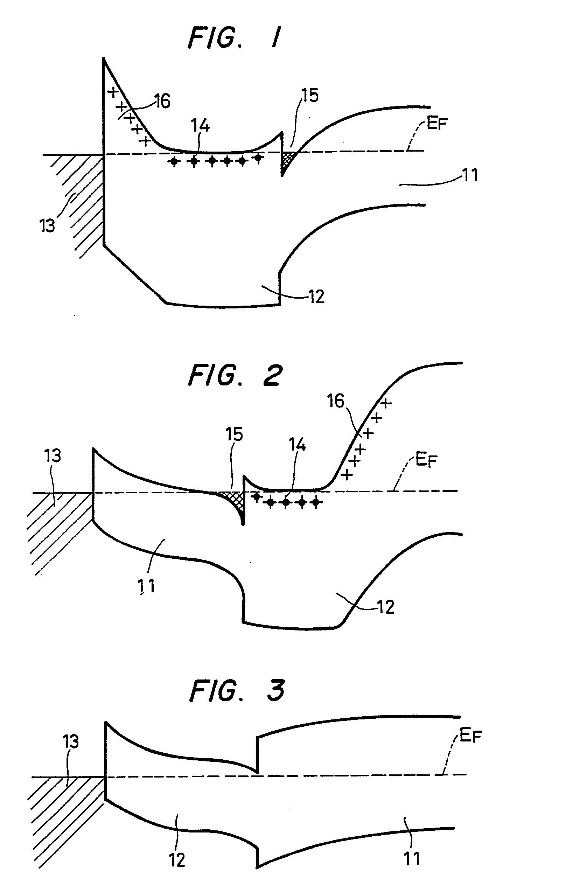

Fig. 1 is an energy band diagram of the active regions of such transistor. In the figure, numeral 13 designates an electrode portion, numeral 12 an AlGaAs layer which contains an impurity, and numbneral 11 a GaAs layer which contains substantially no impurity. In addition, symbol $E_F$ denotes the Fermi level. Numeral 15 in Fig. 1 indicates the carriers which are confined in a two-dimensional potential. The carriers 15 are supplied from a donor level (14) in the AlGaAs (12) and travel within the GaAs containing a very small amount of impurity, so that they are isolated in place from donor impurity ions. As a result, scattering due to impurity potentials decreases conspicuously, and a high mobility can be realized.

Also in a transistor having an energy band diagram as shown in Fig. 2, in which the positions of the GaAs layer and the AlGaAs layer in Fig. 1 are exchanged, carriers are confined in a two-demensional potential, and the impurity scattering can be rendered slight, so that a high mobility can be realized similar to the case of Fig. 1.

Examples of such attempt are published in JAPANESE JOURNAL OF APPLIED PHYSICS Vol. 19 No. 5, May 1980, pp. L225—L227 and MICROWAVES, October 1980, p. 20. German DE—A—29 13 068 discloses a heterojunction semiconductor device which is designed for high carrier mobility and in which a layer having the smaller band gap forms a surface layer on a second layer having the bigger band gap, an intermediate layer being interposed therebetween which has an impurity concentration much less than that of the first layer. The semiconductor materials and the impurity concentrations are selected such that the energy levels of the impurities of the second layer are weaker than the adjacent band of the first layer so that free carriers move from the doped second layer in an adjacent region of the first layer.

## Summary of the Invention

An object of the present invention is to provide a semiconductor device wich has a large number of advantages in manufacture and which has a structure capable of distinctively forming elements of both the enhancement mode and the depletion mode.

In order to accomplish the object, according to the present invention, a semiconductor device having a first semiconductor layer and second semiconductor layer smaller in a forbidden band gap than the first semiconductor layer, the first and second semiconductor layers being arranged so as to form a heterojunction, a first electrode for controlling carriers induced at least in the vicinity of the heterojunction interface, and at least two second electrodes;

said second semiconductor layer existing between said first semiconductor layer and said first electrode, and an impurity identical in conductivity type to the carriers being contained at a high concentration in regions between said second electrodes and a region where the carriers are generated, so as to electrically connect said second electrodes and the carriers induced in the vicinity of said heterojunction interface under said first electrode is so constructed that the first semiconductor layer contains an impurity at a concentration of only at most $10^{15} cm^{-3}$ and the impurity concentration of the regions located between the second electrodes and the region where the carriers are generated is at least $10^{16} cm^{-3}$.

## Brief Description of the Drawings

Figs. 1 and 2 are energy diagrams of hetrojunction field-effect transistors in prior arts;

Fig. 3 is an energy diagram of a transistor according to the present invention;

Figs. 4(a)—4(c) are sectional views showing a manufacturing process for a semiconductor device which is an embodiment of the present invention; and

Figs. 5(a)—5(d) are sectional views showing a manufacturing process in the case of constructing an integrated circuit device in another embodiment of the present invention.

## Description of the Invention

In order to facilitate understanding of the present invention and the advantages thereof, problems in the semiconductor devices explained as the prior arts will be first described.

In the transistor of the structure in Fig. 1, the AlGaAs layer apt to oxidize is exposed to the surface. Therefore, a GaAs layer needs to be further stacked for attaining stable device characteristics.

The device of the structure in Fig. 2 has had the following advantages: (1) Since GaAs difficult of oxidation comes to the surface, the problem of the device in Fig. 1 is not involved. (2) With a compound semiconductor layer, it is difficult to obtain a good oxide film such as an $SiO_2$ film in the case of silicon. Therefore, carriers are usually controlled by forming a Schottky barrier for a gate. In this regard, the Schottky barrier is more easily formed on GaAs than on GaAlAs. (3) In a case where an impurity needs to be introduced, GaAs is higher in the efficiency of introduction than AlGaAs and less suffers the occurrence of lattice defects etc. attendant upon the introduction of the impurity.

This device in Fig. 2, however, has had a serious disadvantage as stated below.

In constructing an integrated circuit, it is more meritorious to employ the two sorts of transistors of the depletion mode being normally on and the enhancement mode being normally off. Both the structures of Figs. 1 and 2 construct, in essence, the normally-on depletion-mode transistors. That is, since a channel portion in the vicinity of the interface between GaAs and AlGaAs is supplied with carriers from the doped AlGaAs at all times, the channel portion and source and drain electrodes are connected without applying a gate voltage, and the normally-on state is established.

With the device of the structure in Fig. 1, however, when the AlGaAs layer is rendered conspicuously thin, the depletion layer of a Schottky electrode extends to the channel portion, so that that the normally-off enhancement-mode transistors can also be fabricated. Thus, even after the structure has been fabricated once, the devices of both the enhancement and depletion modes can be distinctively fabricated by thinning the AlGaAs layer by such an expedient as etching. In contrast, with the structure of Fig. 2, the thickness of the AlGaAs layer cannot be changed once this structure has been fabricated, and hence, it has been impossible to distinctively fabricate the devices of both the enhancement- and depletion-modes.

As understood from the above descriptions, both the semiconductor device illustrated in Figs. 1 and 2 have had the merits with the demerits.

The present invention has been made with note taken of such point. It intends first to readily fabricate devices of both the enhancement mode and depletion mode distinctively, and secondly to eliminate problems in manufacture.

First, the basic principles of the present invention will now be described.

For eliminating the disadvantages of the prior arts as stated before, it is desirable to dope the AlGaAs layer with no impurity and to dope the GaAs layer of good doping efficiency with an impurity, so as to distinctively fabricate the devices of both the enhancement and depletion modes in dependence on the quantities of the impurity. In case of a Schottky type gate, however, gaps have been formed between a channel and source and drain electrodes. As a result, carriers are not induced in the gap portions in the case of the enhancement mode where no donor impurity is added in AlGaAs or GaAs. Accordingly, the channel and the source and drain electrodes cannot be connected, and the transistor cannot operate as such.

The present invention consists in a field effect transistor characterized in that a donor impurity is introduced into a gate electrode side semiconductor of narrower forbidden band gap, or GaAs in the aforementioned example, in the gap region between the channel and the source or drain electrode formed in the case of the Schottky gate, whereas no impurity is introduced into the channel portion directly below a gate electrode. Such structure brings forth the features (1) that since the GaAs and AlGaAs in the vicinity of the channel is devoid of any impurity acting as a scattering center, the mobility increases, and (2) that since the gap portions are supplied with carriers from the donor impurity, the channel portions can be connected with the source and drain electrodes, and the operation of the transistor is ensured.

In case of a hetero-structure field effect transistor made of AlGaAs and GaAs, the difference of the conduction bands of the GaAs and AlGaAs at the interface is approximately 0.3 eV, and the Schottky barrier is approximately 0.6 eV. Accordingly, when the AlGaAs doped with no impurity is employed, a channel is not formed in the state in which no gate voltage is applied.

An energy band diagram in this case is shown in Fig. 3. In the figure, numeral 13 indicates an electrode portion, numeral 12 an AlGaAs layer, numeral 11 of GaAs layer, and symbol $E_F$ the Fermi level. The case of Fig. 3 corresponds to a normally-off state, and the channel is formed by applying a positive voltage to a gate. That is, the transistor is of the enhancement mode.

On the other hand, in order to obtain the normally-on transistor of the depletion mode, the GaAs layer may be doped with a donor impurity. Methods of the impurity doping include a method of adding the impurity simultaneously at the growth of the GaAs layer, a method of adding it from the surface by diffusion after the growth, etc. In case of constructing an integrated circuit, ion implantation is advantageous because parts to be doped with the impurity can be selected after the growth and the accuracy is high.

More specifically, in the course of producing a plurality of enhancement-mode transistors of the present invention, only the required transistors may have an impurity introduced thereinto by, e.g., ion implantation, to change a potential profile and to change the threshold value of the gates. If necessary, the impurity concentration may be raised until the normally-on state is reached, so as to form depletion-mode transistors. In this case, in order to prevent the influence of lattic defects formed by the ion inplantation and the increase of the scattering probability of carriers attributed to the inpurity itself, it is important to perform the ion implantation under the condition that the mean range of ions is at leat 30 nm spaced from the hetero-interface. Here, in the case of the structure of the present invention, the ions are implanted into the GaAs layer, not into the AlGaAs layer. This is also advantageous in that the occurrence of lattice defects etc. attendant upon the impurity ion implantation can be suppressed because GaAs is higher in the efficiency of introduction than AlGaAs. The ion implantation is a technique which is often utilized for the control of threshold values owing to the precise control of the quantity of an impurity. Accordingly, the distinctive fabrication of the devices of both the enhancement and depletion modes having heretofore been impossible is permitted. Moreover, since the GaAs layer which affords a high precision of ion implantation and which is difficult of being oxidized lies at the surface, dispersions in characteristics can be lessened.

In this way, the transistors of the present invention can be implemented as an integrated circuit. In this regard, when the channel length is shortened in order to raise the density of integration, an undesirable phenomenon called "punch-through phenomenon" peculiar to the field effect transistor arises. This is an unfavorable phenomenon in which, with a shortened channel, the punch-through is caused between the source and drain by a voltage applied to the drain, and current flows therebetween, so that a drain current is not completely pinched off by a gate voltage. For example, in case of a storage device, information having been stored in the form of charges runs out due to the punch-through current. Moreover, carriers having been confined in the hetero-interface in two dimensions come to have three-dimensional spread, which is disadvantageous in point of a high speed operation.

The cause of the flow of the punch-through current is that the drain depletion layer extends toward the source side, so the drain depletion layer and the source depletion layer directly influence each other. Thus, the carriers usually confined in the hetero-interface spread also in the thickness direction.

In order to suppress this phenomenon, first, a thin layer in which an impurity opposite in the conductivity type to a source (or drain) impurity is contained at a high concentration is formed in the position of a semiconductor layer of narrower forbidden band gap (the GaAs layer in the case of the heterojunction of GaAS and AlGaAs) close to the interface, thereby to prevent the carriers from having the spread in the thickness direction. Further, one or more layers of an impurity opposite in the conductivity type to the source (or drain) impurity are formed in positions where equipotential lines are prone to spread, so as to restrain the spatial spread of the drain depletion layer. For the effective suppression, the layers need to be formed at a high impurity concentration and with a small thickness.

By disposing the above two sorts of layers in this manner, the punch-through effect can be suppressed, and a semiconductor device of good characteristics can be provided even when the channel is shortened.

When the plurality of layers of the impurity opposite in the conductivity type to the source (or drain) impurity are disposed as described above, there might arise the disadvantage that the threshold voltage becomes too high. The rise of the threshold voltage, however, can be readily controlled by adding a layer of an impurity identical in the conductivity type to the source (or drain) impurity.

While the following embodiments will be explained on semiconductor devices constructed of a GaAs—GaAlAs system, other materials adapted to construct heterojunctions are also suitable. They are, for example, $Al_yGa_{1-y}As$—$Al_xGa_{1-x}As$, GaAs—AlGaAsP, InP—InGaAsP, and InP—InGaAs and InAs—GaAsSb.

Now, the present invention will be described in detail in conjunction with embodiments.

Embodiment 1

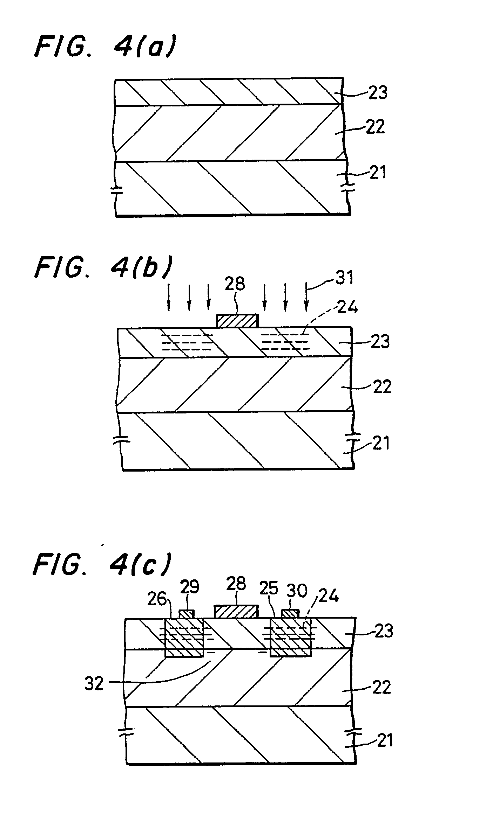

Figs. 4(a)—4(c) are sectional views showing principal manufacturing steps for a semiconductor device according to one embodiment of the present invention.

As shown in Fig. 4(a), on a semi-insulating GaAs substrate 21, an AlGaAs layer (22) in which the composition ratio between Al and Ga was, for example, about 0.3:0.7 was grown to about 1 μm (usually selected between approximately 50 nm—1.5 μm) at a substrate temperature of 600°C, and a GaAs layer (23) was thereafter grown to about 100 nm (usually, about 50—500 nm), by the use of the well-known molecular beam epitaxy method. Both the layers were not intentionally doped with any impurity, and an impurity concentration of the GaAs layer (23) was not higher than $1 \times 10^{15} cm^{-3}$.

A metal, for example, Ti; W to form a gate electrode 28 was deposited on the above epitaxial layer to a thickness of about 2 μm, whereupon using the metal electrode as a mask for ion implantation (self-alignment), Si ions 31 were implanted at a dose of $2 \times 10^{13} cm^{-2}$ by an acceleration voltage of 70 keV. Annealing at 750°C for 30 minutes was performed in order to remove lattice defects generated by the ion implantation and to activate the ions.

Shown at numeral 24 in Fig. 4(b) are the resulting impurity regions. Annealing at a high temperature of 850°C is more desirable for enhancing the activation rate of the ions. However, in order to prevent the blurring of the interface between AlGaAs and GaAs and to prevent the diffusion of impurities; the annealing is conducted at the aforementioned temeprature. Since, in this case, the GaAs layer is subjected to the ion implantation, the activation rate is better than in the case of the prior art in which the AlGaAs layer is subjected to the impurity doping.

As the donor impurity, Ge, Sn, Te, Se, S or the like can be employed besides Si. Ions are implanted at approximately $10^{13}$—$10^{14} cm^{-2}$. The impurity concentration is set, depending upon the extent to which carriers are to be induced, or the required characteristics of the device. The energy of the ion implantation differs depending upon the element to be implanted, and is set in a range of approximately 50—200 keV.

Subsequently, as shown in Fig. 4(c), source (25) and drain electrode regions (26) were formed in continuation to the ion-implanted layers by the conventional alloying, and electrode metal Al (29, 30) was formed. Then, a field effect transistor was finished up. Numeral 32 indicates the carriers induced at the interface.

The source and drain regions are formed in such a way that, for example, an Au-Ge alloy (200 nm) Ni (10 nm) and an Au-Ge alloy (300 nm) are stacked on predetermined parts and are heated at 400°C in $H_2$ for about 5 minutes.

The enhancement-mode transistor thus fabricated attained a mobility about 1.5 times higher than that of a prior-art heterojunction field effect transistor fabricated by doping AlGaAs with a donor at about $3 \times 10^{18} \text{cm}^{-3}$. Moreover, since the surface was of GaAs difficult of oxidation, the transistors could be fabricated with good reproducibility.

Embodiment 2

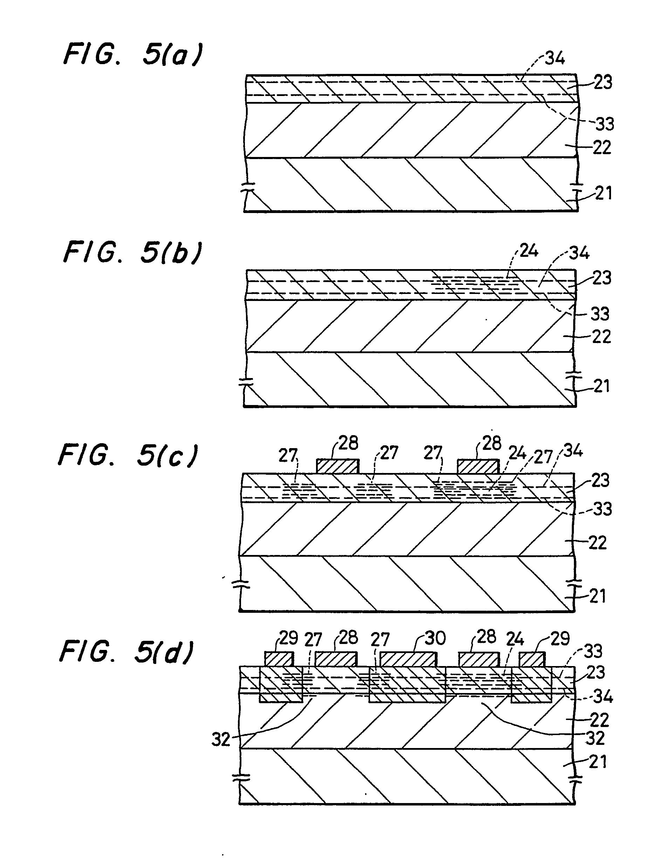

Figs. 5(a)—5(d) are sectional views showing a manufacturing process in the case of constructing an integrated circuit device on a wafer by the use of enhancement-mode and depletion-mode field effect transistors in another embodiment of the present invention.

First, as shown in Fig. 5(a), similarly to Embodiment 1, an AlGaAs layer 22 which was about 1 μm thick and a GaAs layer 23 which was about 100 nm thick were grown on a semi-insulating GaAs substrated 21 by the molecular beam epitaxy. In this case, in order to suppress the punch-through phenomena due to shortened channels, $P^+$GaAs thin layers (33 and 34) each of which was doped with Be at an areal density of $2 \times 10^{12} \text{cm}^{-2}$ and had a thickness of 10 nm were respectively formed within the GaAs layer 23. The first layer 33 for restraining the three-dimensional spread of carriers traveling along the heterojunction interface was formed at a distance of 20 nm from the interface, while the second layer 34 was formed at a distance of 50 nm from the first layer in order to restrain the spread of the drain depletion layer. The part of the GaAs layer 23 other than these two $P^+$ layers was not deliberately doped with any impurity, and had an inpurity concentration not higher than $10^{15} \text{cm}^{-3}$.

It has been confirmed that, when the $P^+$ impurity thin layers fabricated here were too thick or too thin, the effects lower. The optimum value of the thickness was 1—20 nm, and that of the impurity concentration (per unit area) was within a range of $1 \times 10^{12} \text{cm}^{-2}$—$1 \times 10^{13} \text{cm}^{-2}$.

After the fundamental structure was grown in this way, the integrated circuit was formed. As shown in Fig. 5(b), in regions to become the transistors, a region to become the depletion-mode transistor was implanted with Si ions 24 at $2 \times 10^{13} \text{cm}^{-2}$ by 70 keV. In this case, the ions should desirably be implanted into only the GaAs layer 23 and at a distance of about 30 nm from the interface. Thereafter, as shown in Fig. 5(c), gate electrodes 28 were formed, whereupon using them as a mask, the regions to become both the transistors were subjected to the second ion implantation under the same conditions as in Embodiment 1, and the impurity was activated by similar annealing. In the figure, numeral 27 indicates Si introduced by the second ion implantation. Thus, the enhancement-mode and depletion-mode transistors could be simultaneously fabricated as shown in Fig. 5(d).

As the donor impurity, Ge, Sn, Te, Se, S or the like can be employed besides Si. Ions are implanted at approximately $10^{13}$—$10^{14} \text{cm}^{-2}$. The impurity concentration is set, depending upon the extent to which carriers are to be induced, or the required characteristics of the device. The energy of the ion implantation differs depending upon the element to be implanted, and is set in a range of approximately 50—200 keV.

The source and drain regions are formed in such a way that, for example, an Au-Ge alloy (200 nm), Ni (10 nm) and an Au-Ge alloy (300 nm) are stacked on predetermined parts and are heated at 400°C in $H_2$ for about 5 minutes.

In each of Embodiments 1 and 2, in order to facilitate establishing ohmic contact, the regions near the sources or near the sources and drains were doped with an impurity of at least $10^{16} \text{cm}^{-3}$.

While, in both Embodiments 1 and 2, the AlGaAs layer 22 was grown directly on the semi-insulating GaAs substrated 21, similar effects were obtained when, likewise to the prior art, a GaAs layer not doped with any impurity was grown on the semi-insulating GaAs substrate as a buffer layer to a thickness of approximately 0.5 μm, whereupon the same structure as in Embodiment 1 or 2 was fabricated.

The present invention described above will be summarized below.

(1) A semiconductor device having a first semiconductor layer and a second semiconductor layer smaller in a forbidden band gap than the first semiconductor layer, the first and second semiconductor layers forming a heterojunction, at least two electrodes which are electronically connected with the second semiconductor layer, and an electrode for controlling carriers induced in the vicinity of the heterojunction; is characterized in that the second semiconductor layer exists between the first semiconductor layer and the carrier controlling electrode, that an impurity to serve as a donor or acceptor is contained in the first and second semiconductor layers under the gate electrode at a concentration of only at most $10^{15} \text{cm}^{-3}$, and that the impurity of at least $10^{16} \text{cm}^{-3}$ is contained in a region or regions adjoining a source or adjoining a source and a drain.

Owing to the impurity added, carriers are generated in correspondence with the impurity region or regions in the vicinity of the heterojunction interface. (2) An impurity of at least $10^{16} \text{cm}^{-3}$ is contained in that region in the second semiconductor layer which includes at least a part directly under the gate.

Owing to the impurity added, carriers are generated in correspondence with the impurity region in the vicinity of the heterojunction interface.

Here, it is more preferable to employ also the technique described in the above item (1) in which the impurity of at least $10^{16} \text{cm}^{-3}$ is contained in the region or regions adjoining the source or adjoining the source and the drain.

(3) The semiconductor device of the above item (1) or (2) operates at a very high speed because a slight amount of impurity acting as a scattering center is contained in a region in which the carriers travel or a region which adjoins the former region.

(4) The semiconductor device of the above item (1) or (2) can be used as the element of an integrated circuit.

(5) In the IC implementation, the device of item (1) and the device of item (2) can be arranged on an identical wafer as a normally-off transistor and a normally-on transistor respectively.

(6) Further, in the IC implementation, it is recommended that a plurality of thin layers of an impurity opposite in the conductivity type to the introduced impurity be formed within the semiconductor layer of item (2) in order to effectively operate the IC even in case of shortened channels.

## Claims

1. A semiconductor device comprising a first semiconductor layer (22) and a second semiconductor layer (23) smaller in a forbidden band gap than the first semiconcutor layer (22), the first and second semiconductors layers being arranged so as to form a heterojunction, a first electorde (28) for controlling carriers (32) induced at least in the vicinity of the heterojunction interface, and at least two second electrodes (29, 30); wherein said second semiconductor layer (23) exists between said first semiconductor layer (22) and said first electrode (28), and an impurity (24) identical in conductivity type to the carriers (32) is contained at a high concentration in regions (24, 26) located between said second electrodes (29, 30) and a region where the carriers (32) are generated, so as to electrically connect said second electrodes (29, 30) and the carriers (32) induced in the vicinity of said heterojunction interface under said first electrode (28), characterized in that said first semiconductor layer (22) contains an impurity at a concentration of only at most $10^{15} \text{cm}^{-3}$ and in that the impurity concentration of regions (24, 26) is at least $10^{16} \text{cm}^{-3}$.

2. A semiconductor device as defined in claim 1, wherein said second semiconductor layer (23) contains an impurity at a concentration of only at most $10^{15} \text{cm}^{-3}$ under said first elelctrode (28).

3. A semiconductor device as defined in claim 1 or claim 2, wherein under said first electrode (28), said second semiconductor layer (23) contains an impurity at a concentration of only at most $10^{15} \text{cm}^{-3}$ in the region where the carriers are generated and contains the impurity at a concentration of at least $10^{16} \text{cm}^{-3}$ in the other region.

4. A semiconductor device as defined in any of claims 1 to 3, wherein at least one layer (33, 34) of an impurity identical or opposite in the conductivity type to the carriers (32) generated in the vicinity of the heterojunction interface is arranged within said second semiconductor layer (23) so as to have a thickness of 1—20 nm.

5. A semiconductor device as defined in claim 4, wherein the product between impurity concentration and thickness of the impurity layer (33, 34) lies in a range of $1 \times 10^{12} \text{cm}^{-2}$—$1 \times 10^{13} \text{cm}^{-2}$.

6. A semiconductor device as defined in any of claims 1 to 5, wherein said first semiconductor layer (22) is made of AlGaAs, and said second semiconductor layer (23) is made of GaAs.

## Patentansprüche

1. Halbleitereinrichtung, umfassend eine erste Halbleiterschicht (22) sowie eine zweite Halbleiterschicht (23), die einen kleineren Bandabstand hat als die erste Halbleiterschicht (22), wobei die erste und die zweite Halbleiterschicht so angeordnet sind, daß sie einen Hetero-Übergang bilden, eine erste Elektrode (28) zur Steuerung von mindestens in der Umgebung der Hetero-Grenzfläche induzierten Ladungsträgern (32), und mindestens zwei zweite Elektroden (29, 30), wobei die zweite Halblieterschicht (23) zwischen der ersten Halbleiterschicht (22) und der ersten Elektrode (28) vorhanden ist und in Bereichen (24, 26), die sich zwischen den zweiten Elektroden (29, 30) und einem Bereich, in dem die Ladungsträger (32) erzeugt werden, befinden, ein Störstoff (24) des gleichen Leitfähigkeitstyps wie die Ladungsträger (32) in hoher Konzentration erhalten ist, dadurch gekennzeichnet, daß die erste Halbleiterschicht (22) einen Störstoff in einer Konzentration von nur höchstens $10^{15} \text{cm}^{-3}$ enthält, und daß die Störstoffkonzentration der Bereiche (24, 26) mindestens $10^{16} \text{cm}^{-3}$ beträgt.

2. Halbleitereinrichtung nach Anspruch 1, wobei die zweite Halbleiterschicht (23) unter der ersten Elektrode (28) einen Störstoff in einer Konzentration von nur höchstens $10^{15} \text{cm}^{-3}$ enthält.

3. Halbleitereinrichtung nach Anspruch 1 oder 2, wobei unter der ersten Elektrode (28) die zweite Halbleiterschicht (23) in dem Bereich, in dem die Ladungsträger erzeugt werden, einen Störstoff in einer Konzentration von nur höchstens $10^{15} \text{cm}^{-3}$ und im übrigen Bereich in einer Konzentration von mindestens $10^{16} \text{cm}^{-3}$ enthält.

4. Halbleitereinrichtung nach einem der Ansprüche 1 bis 3, wobei innerhalb der zweiten Halbleiterschicht (23) mindestens eine Schicht (33, 34) mit Störstoffen eines Leitfähigkeitstyps, der zu dem der in der Umgebung der Hetero-Grenzfläche erzeugten Ladungsträger (23) gleich oder entgegengesetzt ist, mit einer Dicke von 1 bis 20 nm angeordnet ist.

5. Halbleitereinrichtung nach Anspruch 4, wobei das Produkt aus Störstoffkonzentration und Dicke der Störstoffschicht (33, 34) im Bereich von $1 \times 10^{12} \text{cm}^{-2}$ bis $1 \times 10^{13} \text{cm}^{-2}$ liegt.

6. Halbleitereinrichtung nach einem der Ansprüche 1 bis 5, wobei die erste Halbleiterschicht (22) aus AlGaAs und die zweite Halbleiterschicht (23) aus GaAs besteht.

## Revendications

1. Dispositif à semiconducteurs comportant

une première couche semiconductrice (22) et une seconde couche semiconductrice (23) possédant une bande interdite plus petite que celle de la première couche semiconductrice (22), les première et seconde couches semiconductrices étant disposées de manière à former une hétérojonction,

une première électrode (28) servant à commander des porteurs (32) induits au moins au voisinage de l'interface de l'hétérojonction, et

au moins deux secondes électrodes (29, 30);

et dans lequel ladite seconde couche semiconductrice (23) existe entre ladite première couche semiconductrice (22) et ladite première électrode (28), et une impureté (24) possédant un type de conductivité indentique à ce-lui des porteurs (32) est présente en une concentration élevée dans des régions (24, 26) situées entre lesdites secondes électrodes (29, 30) et une région, dans laquelle les porteurs (32) sont produits, de manière à connecter électriquement lesdites secondes électrodes (29, 30) et les porteurs (32) induits au voisinage de ladite interface de l'hétérojonction au-dessous de ladite première électrode (28),

caractérisé en ce que ladite première couche semiconductrice (22) contient une impureté en une concentration égale seulement au maximum à $10^{15}cm^{-3}$ et en ce que la concentration en impuretés des régions (24, 26) est égale à au moins $10^{16}cm^{-3}$.

2. Dispositif à semiconducteurs selon la revendication 1, dans lequel ladite couche semiconductrice (23) contient une impureté en une concentration égale seulement au maximum à $10^{15}cm^{-3}$ au-dessous de ladite première électrode (28).

3. Dispositif à semiconducteurs selon la revendication 1 ou 2, dans lequel au-dessous de ladite première électrode (28), ladite seconde couche semiconductrice (23) contient une impureté en une concentration égale seulement au maximum à $10^{15}cm^{-3}$ dans la région où les porteurs sont produits, et contient l'impureté en une concentration égale à au moins $10^{16}cm^{-3}$ ailleurs.

4. Dispositif à semiconducteurs selon l'une quelconque des revendications 1 à 3, dans lequel au moins une couche (33, 34) contenant une impureté possédant un type de conductivité identique ou opposé à celui des porteurs (32) produits au voisinage de l'interface de l'hétérojonction est disposée à l'intérieur de ladite seconde couche semiconductrice (23) de manière à posséder une épaisseur égale à 1—20 nm.

5. Dispositif à semiconducteurs selon la revendication 4, dans lequel le produit de la concentration en impuretés par l'épaisseur de la couche d'impuretés (33, 34) se situe dans la gamme $1 \times 10^{12}cm^{-2}$—$1 \times 10^{13}cm^{-2}$.

6. Dispositif à semiconducteurs selon l'une quelconque des revendications 1 à 5, dans lequel ladite première couche semiconductrice (22) est constituée par du AlGaAs et ladite seconde couche semiconductrice (23) est constituée par du GaAs.

## FIG. 1

## FIG. 2

## FIG. 3

## FIG. 4(a)

## FIG. 4(b)

## FIG. 4(c)

*FIG. 5(a)*

*FIG. 5(b)*

*FIG. 5(c)*

*FIG. 5(d)*